Europäisches Patentamt

European Patent Office

Office européen des brevets

(19)

(11) **EP 1 382 124 B1**

(12) **FASCICULE DE BREVET EUROPEEN**

(45) Date de publication et mention
de la délivrance du brevet:
**04.08.2004 Bulletin 2004/32**

(21) Numéro de dépôt: **02724409.4**

(22) Date de dépôt: **09.04.2002**

(51) Int Cl.[7]: **H03M 3/02**

(86) Numéro de dépôt international:
**PCT/FR2002/001229**

(87) Numéro de publication internationale:
**WO 2002/084884 (24.10.2002 Gazette 2002/43)**

(54) **MODULATEUR SIGMA-DELTA PASSE-BANDE ET UTILISATIONS DU MODULATEUR SIGMA-DELTA POUR LA CONVERSION, LA DETECTION ET LA PRODUCTION DE SIGNAUX**

BANDPASS-SIGMA-DELTA-MODULATOR UND ANWENDUNGEN DESSELBEN ZUR WANDLUNG, DETEKTIERUNG UND ERZEUGUNG VON SIGNALEN

BAND-PASS SIGMA-DELTA MODULATOR AND USE OF SIGMA-DELTA MODULATOR FOR CONVERTING, DETECTING AND PRODUCING SIGNALS

(84) Etats contractants désignés:
**DE GB IT**

(30) Priorité: **11.04.2001 FR 0104977**

(43) Date de publication de la demande:
**21.01.2004 Bulletin 2004/04**

(73) Titulaire: **COMMISSARIAT A L'ENERGIE ATOMIQUE**
**75752 Paris Cédex 15 (FR)**

(72) Inventeurs:
 • **ORSIER, Elisabeth**
 **F-38000 GRENOBLE (FR)**
 • **BELLEVILLE, Marc**
 **F-38120 SAINT-EGREVE (FR)**
 • **CONDEMINE, Cyril**
 **F-38100 GRENOBLE (FR)**

(74) Mandataire: **Poulin, Gérard et al**
 **Société BREVATOME**
 **3, rue du Docteur Lancereaux**
 **75008 Paris (FR)**

(56) Documents cités:
**WO-A-01/10033**

 • **DE LA ROSA J M ET AL: "CMOS fully-differential bandpass Sigma&Delta;modulator using switched-current circuits" ELECTRONICS LETTERS, IEE STEVENAGE, GB, vol. 32, no. 3, 1 février 1996 (1996-02-01), pages 156-157, XP006004676 ISSN: 0013-5194 cité dans la demande**

## Description

### Domaine technique

La présente invention concerne un modulateur sigma-delta et, de façon plus précise, un modulateur sigma-delta comprenant au moins un résonateur et un convertisseur interne.

L'invention concerne également l'utilisation d'un tel modulateur sigma-delta pour réaliser des dispositifs de conversion analogique-numérique, des dispositifs de détection de grandeurs physiques et/ou des dispositifs générateurs de signaux.

En raison de ces utilisations très variées, l'invention trouve des applications dans de nombreux domaines techniques.. A titre d'exemple, l'invention peut être mise à profit pour le traitement de signaux de haute fréquence ou encore pour la génération d'un signal de fréquence de référence dans un équipement de communication. Elle peut donc être utilisée dans un téléphone portable ou analogue. L'invention peut aussi être mise à profit pour la réalisation d'instruments de mesure physique, par exemple électromécaniques, optiques, acoustiques, thermiques.ou autres.

### Etat de la technique antérieure

Les modulateurs sigma-delta sont des dispositifs électroniques devenus très communs dans les équipements de traitement du signal. L'utilisation de modulateurs sigma-delta s'est particulièrement développée dans la réalisation de convertisseurs de signaux analogiques en signaux numériques. L'état de la technique concernant les modulateurs sigma-delta, de même qu'un arrière-plan technologique plus large de l'invention est illustré par les documents (1) à (12), dont les références complètes sont données à la fin de la présente description.

Parmi les modulateurs sigma-delta connus, on peut distinguer notamment deux familles de modulateurs qui sont les modulateurs dits "passe-bas" et les modulateurs "passe-bande".

Les modulateurs sigma-delta passe-bas sont construits essentiellement autour d'un ou de plusieurs éléments intégrateurs. Associés à des moyens de filtrage réalisant au moins un filtre passe-bas, ils forment des convertisseurs dits convertisseurs sigma-delta passe-bas. Les modulateurs sigma-delta, illustrés, par exemple, par le document (1), ne sont pas considérés ici. L'invention concerne en effet les modulateurs sigma-delta passe-bande. Ceux-ci, associés à des moyens de filtrage réalisant au moins la fonction de filtre "passe-bande", forment des convertisseurs dits convertisseurs sigma-delta passe-bande.

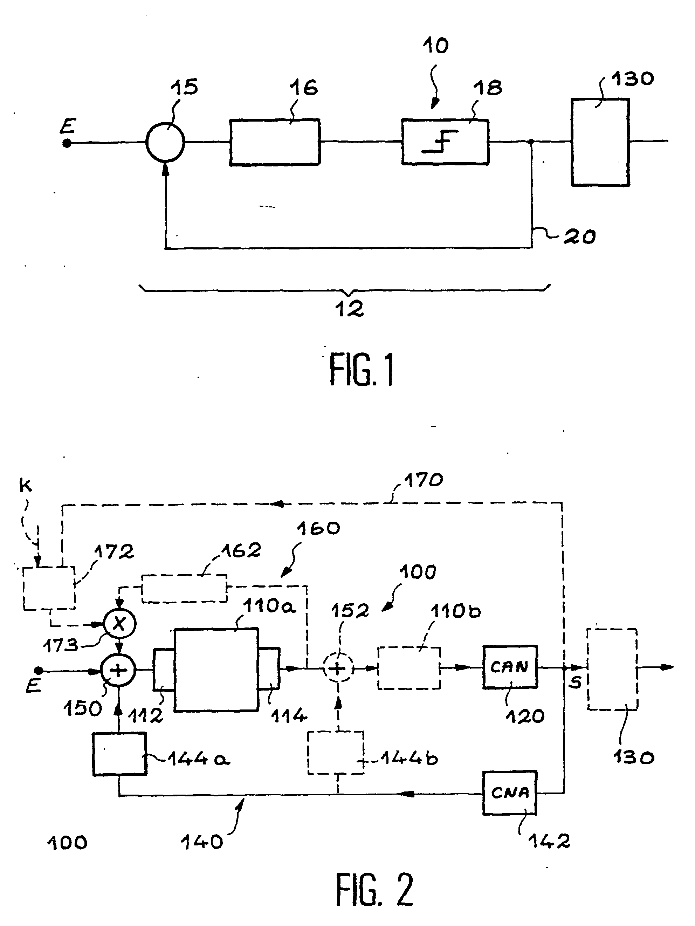

La figure 1 annexée montre de façon schématique et simplifiée les principaux éléments d'un convertisseur sigma-delta passe-bande, de type connu. Ce convertisseur est d'ordre 2. Il contient un résonateur qui peut être comptabilisé comme deux intégrateurs. Le nombre d'intégrateurs définit l'ordre d'un convertisseur sigma-delta.

On peut distinguer dans le convertisseur sigma-delta 10 deux parties principales qui sont un modulateur 12 et des moyens de filtrage 130. Une entrée E du modulateur sigma-delta est connectée dans l'ordre à un résonateur électrique 16, un comparateur 18 et un numérique passe-bande qui constitue ici les moyens de filtrage 130. La sortie du convertisseur sigma-delta correspond à celle des moyens de filtrage 130. Une boucle de rétroaction 20 relie la sortie du comparateur 18 à l'entrée du résonateur 16. Un mélangeur 15 est prévu pour additionner le signal d'entrée appliqué à la borne E et le signal de la boucle de rétroaction 20. La boucle de rétroaction peut comporter, par ailleurs, des composants tels qu'un convertisseur numérique-analogique interne ou un amplificateur. Ceux-ci ne sont pas représentés pour des raisons de simplification.

Un exemple particulier de réalisation du résonateur électrique 16 peut être trouvé, par exemple, dans le document (3) mentionné ci-dessus.

Le comparateur 18 est utilisé comme un convertisseur analogique-numérique interne. Il délivre, par exemple, un signal numérique codé sur un seul bit, qui prend une première valeur logique lorsque le signal analogique délivré par le résonateur électrique dépasse une certaine valeur de seuil, et qui prend une deuxième valeur logique, complémentaire, lorsque le signal analogique en provenance du résonateur est inférieur à cette valeur de seuil. Le signal analogique est ainsi transformé, à la sortie du modulateur en un signal modulé en densité d'impulsions (PDM, Pulse Density Modulation)

Les moyens de filtrage 130 sont du type passe-bande et ont notamment pour fonction d'éliminer, dans le signal modulé, un bruit de quantification inhérent à la transformation du signal analogique en signal quantifié par exemple sur les niveaux de sortie du comparateur.

Lorsque le modulateur sigma-delta est utilisé comme convertisseur analogique-numérique, les moyens de filtrage 130 sont numériques et peuvent aussi être utilisés comme décimateur, c'est-à-dire pour la conversion d'un signal de fréquence élevée codé sur un nombre réduit de bits en un signal de fréquence plus faible codé sur un nombre plus important de bits.

Le résonateur électrique 16 est caractérisé par son facteur de qualité. Celui-ci traduit la largeur d'une bande de fréquence dans laquelle l'amplitude de la résonance dépasse une valeur de seuil. On considère que le facteur de qualité est élevé lorsque l'amplitude de résonance est grande en valeur absolue et la bande de fréquence étroite. La valeur de seuil est définie, comme la valeur maximum de la résonance diminuée de 3 dB.

La qualité du modulateur sigma-delta est liée au facteur de qualité du résonateur. Celle-ci conditionne en particulier l'élimination du bruit de quantification dans la bande passante. En d'autres termes, un modulateur sigma-delta équipé d'un résonateur avec une large bande de résonance, c'est-à-dire avec un piètre facteur de qualité, délivre un signal de sortie entaché d'un fort bruit de quantification. Ceci est le cas malgré le filtrage opéré par les moyens de filtrage 130.

Pour améliorer la qualité du modulateur sigma-delta, une solution consiste à mettre en série plusieurs étages de résonateurs. On obtient ainsi un modulateur sigma-delta d'ordre plus élevé. On peut se reporter à ce sujet aux documents (3) et (4) par exemple.

La multiplication des étages du modulateur se traduit toutefois par un certain nombre de difficultés. Une des difficultés principales est celle de la stabilité de fonctionnement du modulateur sigma-delta. D'autres difficultés sont liées à d'éventuelles interférences des résonateurs électriques entre eux ou avec d'autres composants électriques. Enfin, la multiplication des étages des modulateurs sigma-delta se traduit par une consommation accrue en énergie électrique qui peut s'avérer incompatible avec les sources d'alimentation des équipements portables.

## Exposé de l'invention

La présente invention a pour but de proposer un modulateur sigma-delta qui ne présente pas les limitations des dispositifs mentionnés ci-dessus.

Un but est en particulier de proposer un modulateur sigma-delta présentant un bruit de quantification très faible tout en disposant d'un nombre limité de résonateurs.

Un autre but est de proposer un modulateur sigma-delta qui soit insensible aux interférences avec des circuits électriques ou électroniques environnants, notamment dans des applications de haute fréquence, et qui soit compatible avec les contraintes liées aux équipements portables.

L'invention a enfin pour but de proposer plusieurs applications spécifiques du modulateur sigma-delta qui correspondent à ses particularités.

Pour atteindre ces buts l'invention a plus précisément pour objet un modulateur sigma-delta comprenant :

- au moins un résonateur
- un convertisseur interne pour convertir un signal analogique en provenance du résonateur en un signal numérique à information temporelle,
- une boucle de rétroaction reliant une sortie du convertisseur à une entrée d'excitation du résonateur.

Il convient de préciser que l'invention peut être mise en oeuvre non seulement avec un résonateur linéaire, mais aussi avec un résonateur non-linéaire.

Conformément à l'invention, au moins un résonateur du modulateur sigma-delta est choisi dans le groupe comprenant les résonateurs mécaniques, acoustiques, électromécaniques, électrostatiques, optiques et chimiques.

On entend par résonateur un dispositif susceptible d'entrer en résonance dans une bande de résonance excluant la fréquence nulle et dont la réponse à une fréquence d'excitation hors de la bande de résonance est négligeable. On considère, par exemple, qu'une réponse est négligeable lorsque son amplitude est inférieure d'au moins 10dB à l'amplitude d'une réponse de gain 1.

Le résonateur utilisé dans le modulateur sigma-delta de l'invention n'est pas un résonateur électronique ou électrique. Ceci signifie que la résonance, en soi, n'est pas un phénomène électrique ou électronique. Cependant, il convient de préciser que le signal d'excitation du résonateur ou le signal de sortie du résonateur peuvent parfaitement être des signaux électriques. Le fait que le résonateur ne soit pas électrique ou électronique permet de réduire fortement les interférences avec des circuits électroniques environnants, que ceux-ci travaillent en haute ou en basse fréquence. Par ailleurs, il s'avère que les résonateurs mécaniques ou optiques, par exemple, présentent des facteurs de qualité généralement bien supérieurs à ceux des résonateurs électriques. Une excellente élimination du bruit de quantification peut ainsi être obtenue même avec un nombre d'étages de résonateurs réduit.

Le modulateur sigma-delta de l'invention peut comporter un seul, mais aussi plusieurs résonateurs. L'un, au moins, de ces résonateurs n'est pas un résonateur électrique, comme indiqué ci-dessus. Ceci n'exclut toutefois pas l'association de ce résonateur avec un ou plusieurs autres résonateurs, électroniques ou non.

Lorsque l'entrée d'excitation et/ou la sortie du résonateur ne sont pas électriques, le résonateur peut être associé à au moins une interface électrique c'est-à-dire un organe capable de convertir les signaux physiques, par exemple mécaniques, optiques ou acoustiques en des signaux électriques ou réciproquement. Ceci permet notamment de rendre la sortie compatible avec les moyens de filtrage.

Il convient de noter, par ailleurs, que, dans le cas où l'entrée du résonateur n'est pas une entrée électrique, il est encore possible d'exciter directement le résonateur par un signal d'excitation physique. Une interface électrique n'est alors pas nécessaire à l'entrée du résonateur.

En revanche, lorsque la boucle de rétroaction délivre un signal électrique, et que l'entrée d'excitation est de type physique, la boucle de rétroaction peut être reliée à l'entrée d'excitation, respectivement par l'intermédiaire d'une interface électromécanique, une interface électro-optique, ou une interface électro-acoustique pour le signal. Ces aspects seront encore exposés de façon plus détaillée dans la suite du texte.

Les moyens de filtrage passe-bande sont prévus, comme dans les convertisseurs sigma-delta classiques, pour filtrer le bruit de quantification, et éventuellement effectuer une décimation du signal. Ils peuvent comporter un ou plusieurs éléments de filtre dont le comportement global est celui d'un filtrage passe-bande. La bande est ajustée, de façon classique également, par rapport à celle du résonateur.

Le convertisseur interne du modulateur sigma-delta est un dispositif capable de délivrer un signal numérique à information temporelle. Il s'agit d'un signal de fréquence relativement élevée codé sur un nombre faible de bits, par exemple sur un seul bit. L'information est alors contenue, au moins en partie, dans une densité plus ou moins grande d'impulsions. Un tel convertisseur interne désigné encore par convertisseur analogique-numérique peut se résumer à un simple comparateur destiné à comparer une amplitude du signal analogique en provenance du résonateur à une ou plusieurs valeurs de seuil. Il convient donc de ne pas confondre ce convertisseur analogique-numérique interne avec la fonction de conversion analogique-numérique, réalisée par un modulateur sigma-delta associé aux moyens de filtrage numérique. Cet aspect sera décrit plus en détail dans la suite du texte.

Dans une réalisation particulière du modulateur sigma-delta, le résonateur peut être un oscillateur libre. Dans ce cas, il est équipé d'une boucle de réaction reliant sa sortie à son entrée. Cette boucle peut éventuellement être pourvue de moyens amplificateurs ou comparateurs.

Selon un autre aspect, le résonateur peut être un résonateur à résonance entretenue, par exemple un oscillateur entretenu par un signal d'excitation extérieur.

Selon un perfectionnement, le modulateur sigma-delta de l'invention peut être équipé d'une boucle de régulation reliant une sortie du modulateur à l'entrée d'excitation du résonateur. Cette boucle peut être assortie de moyens de filtrage d'un régulateur et/ou d'un comparateur pour comparer le signal de sortie, ou une caractéristique de ce signal, à une valeur ou un signal de consigne. La boucle de régulation a alors essentiellement pour fonction -de stabiliser le comportement du. modulateur, par exemple lorsque celui-ci est utilisé pour générer un signal.

L'invention concerne également un dispositif de conversion analogique-numérique d'un signal comprenant une entrée de signal analogique et un convertisseur sigma-delta tel que décrit précédemment. L'entrée de signal analogique est alors reliée à l'entrée d'excitation du résonateur. Le signal appliqué à l'entrée du résonateur est un signal analogique à convertir. Le terme "signal" est utilisé ici dans un sens très général qui n'exclut pas l'application à l'entrée du convertisseur d'un signal continu et invariable. Le convertisseur peut en effet être utilisé dans toutes les applications dans lesquelles un signal provenant d'une source de signal, ou une tension provenant, par exemple, d'un instrument de mesure, doivent être convertis en des valeurs numériques.

Lorsque l'entrée d'excitation du résonateur est une entrée physique, alors que le signal à convertir est un signal électrique, l'entrée analogique peut être reliée à l'entrée d'excitation par l'intermédiaire d'une interface électromécanique ou électro-optique de la façon déjà évoquée.

L'invention a encore pour objet un générateur de signaux numériques ou analogiques comprenant un modulateur sigma-delta tel que décrit, dans lequel au moins un résonateur est un oscillateur et éventuellement des moyens de filtrage comportant un filtre numérique ou analogique.

Le filtre analogique permet de convertir en un signal de sortie analogique le signal numérique modulé en densité d'impulsions, disponible à la sortie du convertisseur analogique-numérique interne du modulateur sigma-delta. Ce signal de sortie est, par exemple, un signal sinusoïdal.

Lorsque le modulateur sigma-delta est utilisé comme générateur de signaux, le résonateur peut être un oscillateur libre. Dans ce cas, aucun signal extérieur n'est appliqué à l'entrée d'excitation du résonateur. Celui-ci reste toutefois associé à une boucle de contre-réaction reliant sa sortie à son entrée d'excitation. Cette boucle permet de transformer lé résonateur en oscillateur libre.

L'invention concerne enfin l'utilisation d'un modulateur sigma-delta dans un dispositif de mesure d'une grandeur physique. Le dispositif de mesure comprend un résonateur de détection sensible à une grandeur physique et un modulateur sigma-delta tel que décrit précédemment.

Il convient de préciser que la grandeur physique à laquelle le résonateur est sensible n'est pas liée au signal d'excitation appliqué ou non à l'entrée du résonateur. La grandeur physique est une grandeur qui modifie l'amplitude de résonance du résonateur. A titre d'exemple, lorsque le résonateur est un gyromètre vibrant, la grandeur physique à mesurer peut être une force de Coriolis. Pour d'autres résonateurs, la grandeur physique peut être une température.

La grandeur physique considérée ici se distingue donc d'une grandeur physique provenant d'un capteur extérieur au modulateur sigma-delta et dont le signal de mesure analogique serait appliqué à l'entrée d'excitation du résonateur pour une conversion en un signal numérique. Ceci correspondrait en effet à une utilisation du modulateur sigma-delta dans un convertisseur analogique-numérique de la façon examinée précédemment, et non en soi comme un dispositif de mesure.

Selon une réalisation particulière d'un dispositif de mesure conforme à l'invention, celui-ci peut comporter des moyens d'excitation du résonateur de détection, sous la forme d'un second résonateur, dit d'excitation, couplé au résonateur de détection. Le résonateur d'excitation peut faire partie d'un deuxième modulateur sigma-delta distinct. Un exemple particulier du couplage défini ci-dessus peut être la force de Coriolis.

D'autres caractéristiques et avantages de l'invention ressortiront de la description qui va suivre, en référence aux figures des dessins annexés. Cette description est donnée à titre purement illustratif et non limitatif.

Brève description des figures

- La figure 1, déjà décrite est une représentation schématique simplifiée d'un convertisseur sigma-delta de type connu, faisant partie de l'état de la technique.
- Les figures 2 et 3, sont des représentations schématiques de modulateurs sigma-delta conformes à l'invention.
- Les figures 4 à 6 sont des représentations schématiques illustrant des utilisations particulières de modulateurs sigma-delta conformes à l'invention.

**Description détaillée de modes de mise en oeuvre de l'invention.**

Dans la description qui suit, des parties identiques, similaires ou équivalentes des différentes figures sont repérées par les mêmes références numériques. On peut se reporter ainsi d'une figure à l'autre, en évitant la répétition de la description des éléments déjà évoqués.

Le modulateur sigma-delta 100 de la figure 2 comprend entre une entrée E et une sortie S, dans l'ordre, un premier résonateur 110a, un deuxième résonateur 110b, indiqué en trait discontinu, un convertisseur analogique-numérique 120. Une boucle de rétroaction 140 relie la sortie du convertisseur analogique-numérique 120 à l'entrée 112 du premier résonateur 110a. Un opérateur 130, indiqué en trait discontinu peut être éventuellement associé au modulateur pour former un convertisseur sigma-delta.

Un signal de rétroaction analogique est formé au moyen d'un convertisseur numérique-analogique 142, et est appliqué à l'entrée 112 par l'intermédiaire d'un amplificateur 144a. Un additionneur 150 est prévu pour ajouter le signal de rétroaction à un éventuel signal d'entrée appliqué à l'entrée E du modulateur sigma-delta.

Le premier résonateur 110a est par exemple un résonateur optique, acoustique ou mécanique. Il est pourvu d'une première interface 112, destinée à transformer un signal électrique d'entrée et/ou un signal électrique de rétroaction en un signal mécanique, acoustique ou optique. A l'inverse, une deuxième interface 114, disposée à la sortie du résonateur 110a, est prévue pour convertir un signal physique résonnant en un signal électrique, en direction du convertisseur analogique-numérique 120. Les interfaces 112 et 114 sont par exemple un transducteur acoustique, du type haut-parleur, et un microphone, lorsque le résonateur 110a est une cavité acoustique. Un exemple de modulateur sigma-delta équipé d'une telle cavité est examiné plus en détail dans la suite du texte.

Lorsque le résonateur est du type électrostatique ou électromécanique, c'est-à-dire s'il peut être excité par un signal électrique, les interfaces 112 et/ou 114 sont supprimées.

Le deuxième résonateur 110b, représenté en trait discontinu, peut être un résonateur comparable au premier résonateur ou, éventuellement, un résonateur électrique. Il permet d'augmenter l'ordre du modulateur sigma-delta et donc ses performances. Une branche de la boucle de rétroaction 140, pourvue d'un amplificateur 144b est connectée à une entrée du deuxième résonateur. Le signal de rétroaction est ajouté au signal de sortie du premier résonateur par un additionneur 152.

Il convient de préciser que le deuxième résonateur 110b, et donc le deuxième amplificateur 144b, peuvent être éliminés. Ils peuvent également être remplacés par un nombre plus important de résonateurs connectés selon le même schéma, en série avec le premier résonateur 110a.

Selon l'utilisation que l'on souhaite faire du modulateur sigma-delta, différents types de signaux peuvent être appliqués à l'entrée E. Dans une utilisation comme convertisseur analogique-numérique, on peut y appliquer, par exemple, un signal analogique ou une simple tension à convertir en valeurs numériques. Dans une utilisation comme générateur de signaux ou comme dispositif de mesure, un signal d'excitation destiné à entretenir une résonance peut être appliqué à l'entrée E. Enfin il est encore possible de n'appliquer aucun signal extérieur à l'entrée E.

Le résonateur 110a peut en effet être utilisé comme un oscillateur libre. Dans ce cas, une boucle de réaction 160, équipée, par exemple, d'un amplificateur 162, est connectée entre la sortie du résonateur et son entrée. La boucle de réaction 160, représentée en trait discontinu sur la figure 2, est connectée à l'additionneur 150 en amont du résonateur 110a.

Une boucle de régulation 170, représentée également en trait discontinu, peut être prévue entre la sortie S et l'entrée E pour stabiliser le fonctionnement du modulateur sigma-delta. Une telle boucle peut être notamment mise à profit pour stabiliser l'amplitude du signal de sortie lorsque le modulateur sigma-delta est utilisé comme générateur de signaux. Dans l'exemple de la figure 2, La boucle de régulation est équipée d'un régulateur 172 avec une entrée de consigne K, pour effectuer une comparaison entre une caractéristique du signal de sortie disponible à la sortie S et une caractéristique de consigne appliquée à l'entrée de consigne K. Il s'agit, par exemple, d'une consigne représentative d'une amplitude d'oscillation. Le régulateur 172 peut comporter par ailleurs des moyens de filtrage.

On peut observer que, dans la réalisation particulière illustrée à la figure 2, la boucle de régulation 170 n'est pas directement reliée à l'entrée E. Un multiplieur 173, reçoit les sorties du régulateur 172 et de l'amplificateur 162 pour les multiplier avant de les appliquer à l'additionneur 150 de l'entrée. Lorsque l'amplificateur 162 comprend un comparateur à sortie logique 0 ou 1, la multiplication revient à appliquer ou non le signal du régulateur à l'entrée.

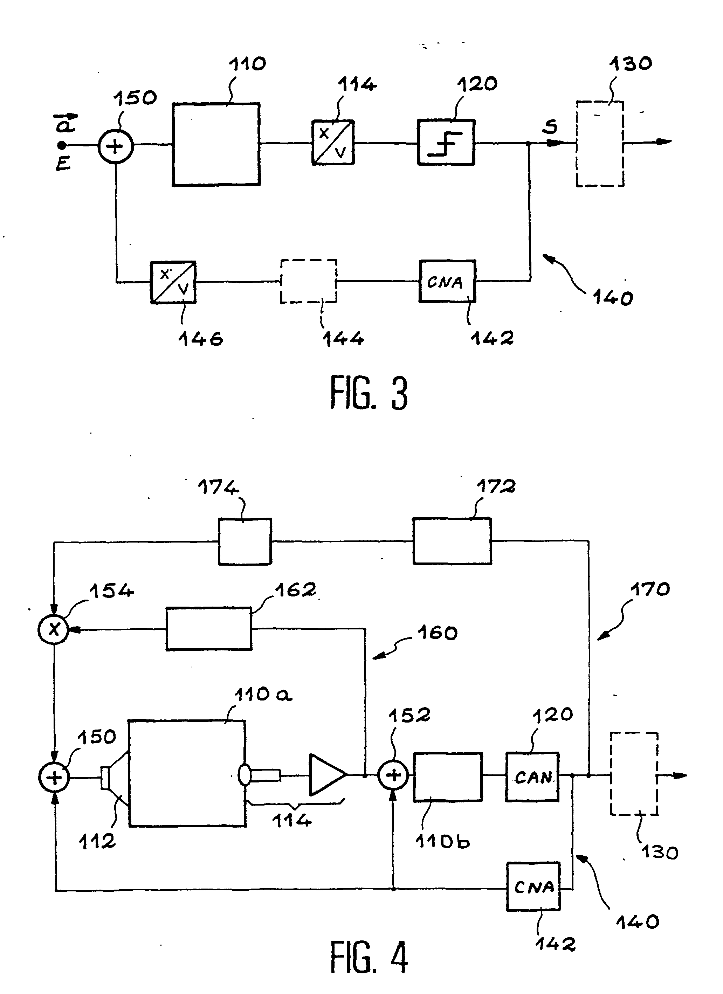

La figure 3 montre un autre exemple de modulateur sigma-delta conforme à l'invention. Dans cet exemple, on considère que le résonateur 110 est un résonateur mécanique dont l'entrée est sensible à une force ou une accélération $\bar{a}$. Le résonateur est équipé en sa sortie d'une interface 114 capable de convertir un signal de résonance mécanique en un signal électrique. Le signal électrique est ensuite dirigé vers un convertisseur analogique-numérique 120.

Contrairement au dispositif de la figure 2 le signal appliqué à l'entrée E du modulateur sigma-delta n'est pas un signal électrique, de sorte qu'une interface comparable à l'interface 112 de la figure 2 n'est pas nécessaire. En revanche, la boucle de rétroaction 140 du modulateur sigma-delta de la figure 3 comprend en plus du convertisseur numérique-analogique 142 une interface 146 capable de convertir un signal analogique électrique délivré par le convertisseur numérique-analogique 142 en un signal mécanique, par exemple une accélération, qui est compatible avec l'entrée d'excitation du résonateur. Entre le convertisseur numérique-analogique 142 et l'interface 146, un amplificateur 144 peut être prévu.

On peut observer, par ailleurs, que le modulateur sigma-delta de la figure 3, ne comprend qu'un seul résonateur 110.

La figure 4, décrite ci-après, illustre une réalisation particulière d'un modulateur sigma-delta conforme à l'invention dans lequel le résonateur est un gyromètre acoustique avec une cavité en silicium. Une description d'un gyromètre acoustique peut être trouvée par exemple dans le document (7), mentionné précédemment.

Sur la figure 4, la cavité est repérée par la référence 110a par analogie avec la figure 2.- Elle constitue en effet un résonateur à entrée mécanique, plus précisément à entrée acoustique, et à sortie également acoustique. Une première interface 112, représentée sous la forme d'un haut-parleur, est un transducteur capable de transformer un signal électrique en provenance d'un additionneur d'entrée 150, en un signal acoustique appliqué à la cavité, c'est-à-dire au résonateur 110a.

A la sortie de la cavité, un microphone capacitif 114, associé à un amplificateur, joue le rôle inverse. Il convertit un signal acoustique de la cavité en un signal électrique susceptible d'être fourni à un convertisseur analogique-numérique 120.

Une boucle de réaction positive 160, équipée d'un amplificateur 162, éventuellement associé à un comparateur non représenté, permet de réinjecter une partie du signal électrique délivré par le microphone 114 à l'entrée de la cavité 110a par l'intermédiaire du convertisseur 112. Cette réaction permet de transformer le résonateur en oscillateur libre.

Le convertisseur analogique-numérique 140 indiqué ci-dessus, de même qu'un convertisseur numérique-analogique 142 de la boucle de rétroaction 140 peuvent être des convertisseurs à un bit. Par ailleurs, un deuxième résonateur électronique 110b est connecté en série avec le gyromètre acoustique. La description de ces éléments n'est pas reprise ici. On peut se référer à la description donnée en relation avec la figure 2.

La sortie du convertisseur analogique-numérique 120 est reliée à un opérateur de sortie 130 qui comprend un filtre analogique capable de transformer la sortie numérique modulée en densité d'impulsions en un signal de sortie, par exemple, sinusoïdal. Cette utilisation du modulateur sigma-delta est par exemple celle d'un générateur de signaux.

La sortie du convertisseur analogique-numérique 120 est aussi reliée à une boucle de régulation 170 connectée à l'entrée du premier résonateur 110a, pour stabiliser le signal de sortie en amplitude. Une stabilisation en fréquence est en outre assurée par la boucle 160.

La boucle de régulation comprend par exemple un filtre décimateur 172, pour convertir le signal modulé du convertisseur analogique-numérique 120, codé sur un bit, en un signal codé sur plusieurs bits. Le décimateur est suivi d'un régulateur 174 de type PID (Proportionnel Intégral Dérivée) qui permet de minimiser une différence entre le signal de sortie, ou une caractéristique de ce signal, et une consigne qui représente l'amplitude à atteindre. La sortie du régulateur PID est additionnée au signal de la boucle de réaction 160 ou multipliée par ce signal. Un additionneur 154 ou un multiplieur est prévu à cet effet. La réalisation du dispositif avec un multiplieur présente un coût réduit et l'avantage d'un fonctionnement efficace.

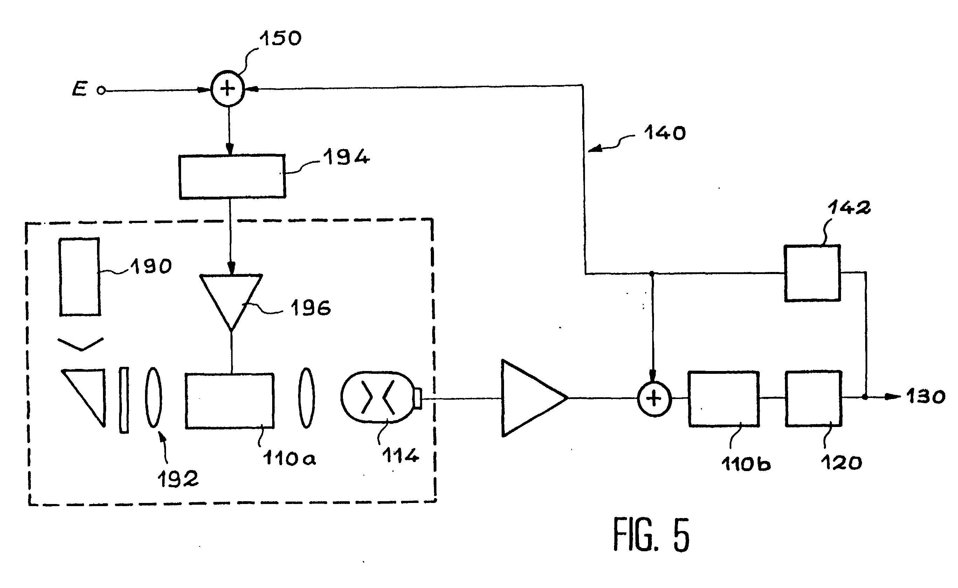

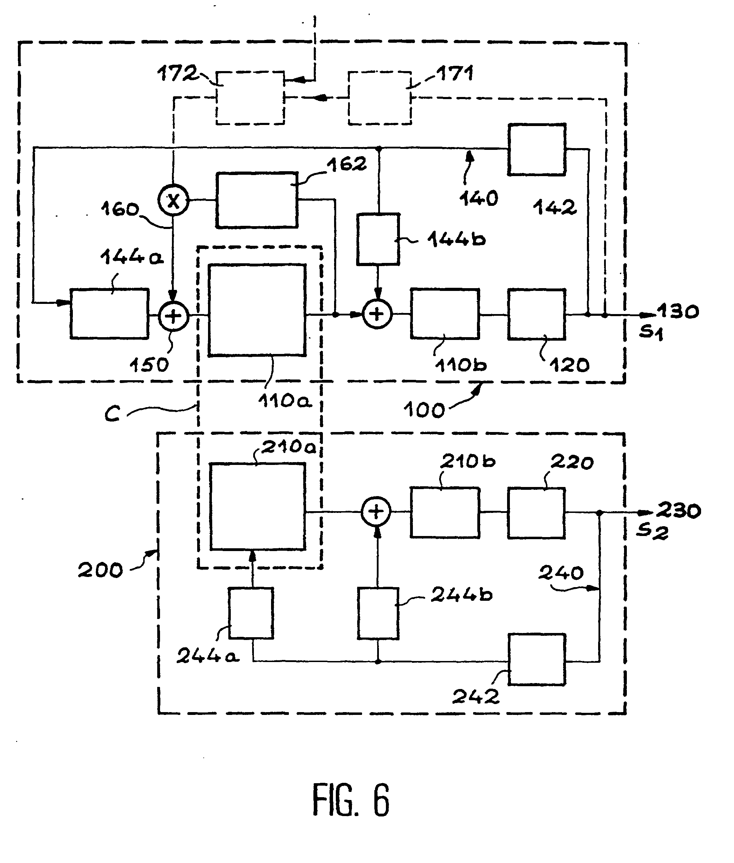

La figure 5 illustre l'utilisation d'un modulateur sigma-delta conforme à l'invention pour le contrôle de l'accord de résonance d'un résonateur. Dans le cas du dispositif de la figure 6, le résonateur 110a est un modulateur électrooptique. Le résonateur présente deux entrées. Une première entrée optique est reliée à un laser HeNe d'excitation 190, couplé au résonateur par l'intermédiaire d'un ensemble optique 192 composé d'un prisme, d'un polarisateur et d'une lentille. Une deuxième entrée est une entrée électrique reliée à l'entrée E du modulateur sigma-delta par un circuit d'adaptation 194 et un amplificateur 196. La sortie optique du résonateur est connectée au convertisseur analogique-numérique 120 par l'intermédiaire d'une interface optoélectronique 114 sous la forme d'un interféromètre de Fabry Pérot associé à une photodiode et à un amplificateur non référencé.

Dans cette réalisation particulière du modulateur sigma-delta, la boucle de rétroaction 140 est connectée à l'entrée électrique du résonateur par un additionneur 150.

Dans cette application, le résonateur, c'est-à-dire le modulateur électrooptique, est utilisé pour contrôler la fréquence de modulation du signal optique.

Une description plus complète d'un modulateur électrooptique du type utilisé dans le modulateur sigma-delta de la figure 6, peut être trouvée dans le document (9).

Un dernier exemple particulier de mise en oeuvre de l'invention est donné par la figure 6. La figure 6 montre un système comprenant deux modulateurs sigma-delta 100, 200 couplés. Ce type de gyromètre vibrant est utilisé comme un système à deux oscillateurs mécaniques couplés. Les oscillateurs servent de résonateur pour les modulateurs sigma-delta. Le mouvement du premier oscillateur mécanique, utilisé pour l'excitation, est transmis au second oscillateur, utilisé pour la détection par un couplage provenant de la force de Coriolis comme décrit ci-dessus. La détection concerne une vitesse de rotation angulaire.

Les forces de Coriolis, notées $F_{coriolis}$ peuvent être exprimées de la façon suivante :

$$\bar{F}_{coriolis} = 2 * m * \bar{V} \wedge \bar{\Omega}$$

Dans cette expression, m désigne la masse du premier oscillateur mécanique 110a, V, la vitesse du premier oscillateur mécanique et $\Omega$ la vitesse de rotation à mesurer. On déduit $\Omega$ de la mesure du mouvement du second oscillateur.

Toute variation de l'excitation c'est-à-dire de la vitesse V se retrouve dans le signal de détection. On mesure la vitesse V pour démoduler la détection.

Pour une vitesse de rotation donnée, le signal de sortie est maximum lorsque le deuxième oscillateur 210a est à sa fréquence de résonance et que le premier oscillateur présente une vitesse maximum. Bien que ce ne soit pas indispensable, il est ainsi préférable que les deux oscillateurs soient choisis avec une fréquence de résonance semblable ou proche, c'est-à-dire par exemple distantes de quelques Hertz.

Les oscillateurs du gyromètre vibrant peuvent être commandés de façon électrostatique par le biais de condensateurs. Le signal de sortie peut de la même façon être établi par la mesure de la variation de la capacité de condensateurs.

Finalement, le signal d'entrée et de sortie des résonateurs, en l'occurrence des oscillateurs, sont des signaux électriques. Des condensateurs, non représentés, servent d'interfaces et transforment la puissance électrique en forces électrostatiques et donc en déplacements mécaniques, et inversement.

Dans la description qui suit, on utilise les mêmes références numériques que dans les figures précédentes pour désigner les éléments du premier modulateur sigma-delta et on utilise encore les mêmes références augmentées de 100, pour désigner les éléments similaires ou équivalents du deuxième modulateur sigma-delta.

Le premier modulateur sigma-delta 100 comprend un résonateur 110a qui, associé à une boucle de réaction 160 avec un amplificateur 162, forme le premier oscillateur dit d'excitation. Celui-ci est asservi à sa propre fréquence de résonance. On peut noter que la boucle de réaction 160 peut éventuellement être éliminée lorsqu'un signal d'excitation extérieur est appliqué à l'entrée du premier résonateur 110a, c'est-à-dire à l'additionneur 150.

La boucle de rétroaction 140 du premier modulateur sigma-delta 100 est pourvue d'un régulateur 144a avec une entrée de consigne de déplacement. Le régulateur 144a est comparable à l'amplificateur 144a de la figure 2, et est destiné à appliquer une rétroaction à l'entrée de l'oscillateur d'excitation 110a. Un autre amplificateur 144b est prévue pour la rétroaction d'un deuxième résonateur électronique 110b.

Le signal de modulation disponible à la sortie $S_1$ du convertisseur analogique-numérique 120 du premier modulateur sigma-delta est dirigé vers un opérateur de sortie 130 non représenté pour établir la vitesse V évoquée précédemment.

Selon un perfectionnement, représenté en trait discontinu, une boucle de rétroaction comprenant des filtres 171 et un régulateur 172 peuvent être connectés entre la sortie S1 et l'entrée du résonateur 110a. Le régulateur 174 est également pourvu d'une entrée de consigne.

Le deuxième modulateur sigma-delta 200 comprend un résonateur 210a couplé mécaniquement au résonateur 110a du premier modulateur sigma-delta 100. Le couplage est indiqué sur la figure au moyen d'une ligne discontinue C.

Les références 210b 220, 240, 242, 244a et 244b désignent des parties équivalentes aux parties 110b, 120, 140, 144a et 144b déjà décrites ci-dessus ou en relation avec la figure 2. Leur description n'est donc pas reprise.

La sortie $S_2$ du convertisseur analogique-numérique 220 du deuxième modulateur sigma-delta 200 est également dirigée vers un opérateur de sortie 230, non représenté, pour délivrer un signal de sortie représentatif de la force de Coriolis.

Un calculateur peut être prévu pour établir la vitesse de rotation $\Omega$ évoquée précédemment à partir de la donnée de la force de Coriolis et de la vitesse V.

Documents cités

(1)
"Multi-purpose interface for sensor systems fabricated by CMOS technology with post-processing",
Carlos Azeredo Leme at Henry Baltes,
Sensors and Actuators A.37-38 (1993) 77-81, ©
1993, Elsevier Sequoia
(2)

"A 2.5 MHz 55dB Switched-current BandPass ΣΔ Modulator for AM Signal Conversion",
J.M. de la Rosa, B. Pérez-Verdù, F. Medeiro, et A. Rodriguez-Vazquez,
Instituto de Miceoelectronica de Sevilla -CNM.
ESSCIRC'97, Paris, *France, pp. 156-159
(3)
"A 10.7-MHz N-Path fourth-Order Bandpass Sigma-Delta Modulator"
Fabrizio Francesconi, Valentiono Liberali, et Franco Maloberti,
Micronova Sistemi S.r.l.
ESSCIRC'96, pp. 156-159
(4)
"An Eighth-Order BandPass ΣΔ Modulator for A/D Conversion in Digital Radio",
Loai Louis, John Abcarius, et Gordon W. Roberts,
IEEE JOURNAL OF SOLID-STATE CIRCUITS, Vol. 34 N°4, APRIL 1999.
(5)
"An Invertigation of Bandpass Sigma-Delta A/D Converters"
Yvan Botteron et Behrouz Nowrouzian,
1997 IEEE, Proceedings of the Midwest Symposium on circuits and systems, vol. 1, pp. 293.6
(6)
"BandPass Sigma-Delta Modulator for wideband IF signals"
Luca Daniel, Marco Sabatini,
BandPass Sigma-Delta Modulator for wideband IF signals, june 10, 1999.
(7)
"Preliminary Results on a Silicon Gyrometer Based on Acoustic Mode Coupling in Small Cavities"
Tarik Bourouina, Anne Exertier, Serge Spirkovitch, Bernard Chaumet et Eric Pleska,
JOURNAL OF MICROELECTROMECHANICAL SYSTEMS, vol. 6, n° 4, December 1997.
(8)
"OPTICAL SYSTEM FOR PRESSURE AND TEMPERATURE SENSING"
K. Seibert, D. Largeau, B. Bonvalot et D.T. Angelidis, P. Parsons,
The 7th International Conference on Solid-State Sensors and Actuators.
(9)
"RESONANTLY ENHENCED RADO FREQUENCY ELECTROOPTIC PHASE MODULATOR"
Chi Man Shum et Edward A. Whittaker,
APPLIED OPTICS, Vol. 29, n° 3, 20 January 1990.
(10)
"An Integrated CMOS Micromechanical Resonator High-Q Oscillator,
de Clark T.-C Nguyen, Member, IEEE et Roger T. Howe,
IEEE JOURNAL OF SOLID-STATE CIRCUITS, VOL. 34, N°4, April 1999, ©1999 IEEE.
(11)
"High-Accuracy circuits for On-chip Capacitance Ratio Testing or Sensor Readout,
Yumin Cao et Gabor C. Temes,
IEEE TRANSACTIONS ON CIRCUITS AND SYSTEMS-II : ANALOG AND DIGITAL SIGNAL PROCESSINS, vol. 41, n°9, September 1994, ©1994 IEEE.
(12)
WO-98/27402

## Revendications

1. Modulateur sigma-delta comprenant

   - au moins un résonateur (110, 110a, 110b),
   - un convertisseur (120) pour convertir un signal analogique en provenance du résonateur en un signal numérique à information temporelle, et
   - une boucle de rétroaction (140) reliant une sortie du convertisseur à une entrée d'excitation du résonateur,

   **caractérisé en ce que** au moins un résonateur (110, 110a) du modulateur est un résonateur choisi dans le groupe comprenant les résonateurs mécaniques, acoustiques, électromécaniques, électrostatiques, optiques, chimiques, le résonateur présentant une entrée d'excitation mécanique, optique ou acoustique, la boucle de rétroaction étant reliée à l'entrée d'excitation respectivement par l'intermédiaire d'une interface électromécanique, d'une interface électro-acoustique, ou d'une interface électro-optique du signal.

2. Modulateur sigma-delta selon la revendication 1, dans lequel le résonateur (110a) est un oscillateur libre et comprend une boucle de réaction (160) reliant une sortie du résonateur à une entrée d'excitation du résonateur.

3. Modulateur selon la revendication 1, comprenant une boucle de régulation (170) reliant une sortie du modulateur à une entrée d'excitation du résonateur.

4. Convertisseur sigma-delta comprenant un modulateur conforme à la revendication 1 et des moyens de filtrage passe-bande (130) connectés à une sortie du modulateur.

5. Dispositif de conversion analogique-numérique d'un signal comprenant une entrée de signal analogique (E) et un convertisseur sigma-delta, conforme à la revendication 4, l'entrée de signal analogique étant reliée à l'entrée d'excitation du résonateur.

6. Dispositif selon la revendication 5, dans lequel l'entrée analogique est reliée à l'entrée d'excitation par l'intermédiaire d'une interface électromécanique ou électro-optique (112) ou électro-acoustique.

7. Générateur de signaux comprenant un modulateur sigma-delta conforme à la revendication 1, dans lequel au moins un premier résonateur (110a) est un oscillateur libre.

8. Dispositif de mesure d'une grandeur physique comprenant un résonateur de détection sensible à ladite grandeur physique et un modulateur sigma-delta conforme à la revendication 1, incluant ledit résonateur de détection.

9. Dispositif de mesure selon la revendication 8, dans lequel le résonateur de détection (110a, 210a) est un oscillateur libre.

10. Dispositif de mesure selon la revendication 8, comprenant des moyens d'excitation du résonateur de détection (210a), avec un second résonateur, dit d'excitation, couplé au résonateur de détection.

11. Dispositif selon la revendication 10, comprenant un second modulateur sigma-delta incluant le résonateur d'excitation.

12. Dispositif de mesure selon la revendication 8, dans lequel le résonateur de détection est couplé au résonateur d'excitation par une grandeur physique.

13. Dispositif selon la revendication 12, dans lequel la grandeur physique est une force de Coriolis.

14. Utilisation d'un modulateur sigma-delta selon la revendication 1, dans un dispositif choisi parmi un convertisseur analogique numérique, un détecteur de grandeur physique, et un générateur de signaux.

**Patentansprüche**

1. Sigma-Delta-Modulator, umfassend:

   - wenigstens einen Resonator (110, 110a, 110b),
   - einen Konverter (120) zur Umwandlung eines von dem Resonator stammenden analogen Signals in ein digitales Zeitinformationssignal, und
   - eine Rückkopplungsschleife (140), die einen Ausgang des Konverters mit einem Anregungseingang des Resonators verbindet,

   **dadurch gekennzeichnet, dass** wenigstens ein Resonator (110, 110a) des Modulators ein aus der Gruppe ausgewählter Resonator ist, welche die mechanischen, akustischen, elektromechanischen, elektrostatischen, optischen, chemischen Resonatoren umfasst, wobei der Resonator einen mechanischen, optischen oder akustischen Anregungseingang aufweist und die Rückkopplungsschleife mit dem Anregungseingang jeweils durch eine elektromechanische Schnitt- bzw. Kopplungsstelle, eine elektroakustische Kopplungsstelle oder eine elektrooptische Kopplungsstelle des Signals verbunden ist.

2. Sigma-Delta-Modulator nach Anspruch 1, bei dem der Resonator (110a) ein freier Oszillator ist und eine Rückkopplungsschleife (160) umfasst, die einen Ausgang des Resonators mit einem Anregungseingang des Resonators verbindet.

3. Modulator nach Anspruch 1 mit einer Regelungsschleife (170), die einen Ausgang des Modulators mit einem Anregungseingang des Resonators verbindet.

4. Sigma-Delta-Konverter mit einem Modulator nach Anspruch 1 und Bandpassfiltereinrichtungen (130), verbunden mit einem Ausgang des Modulators.

5. Analog-Digitalumwandlungsvorrichtung eines Signals mit einem analogen Signaleingang (E) und einem Sigma-Delta-Konverter nach Anspruch 4, wobei der analoge Signaleingang mit dem Anregungseingang des Resonators verbunden ist.

6. Vorrichtung nach Anspruch 5, bei welcher der analoge Eingang mit dem Anregungseingang durch eine elektromechanische oder elektrooptische Kopplungsstelle (112) verbunden ist.

7. Signalgenerator mit einem Sigma-Delta-Modulator nach Anspruch 1, bei dem wenigstens ein erster Resonator (110a) ein freier Oszillator ist.

8. Messvorrichtung einer physikalischen Größe, einen für die genannte physikalische Größe empfindliche Detektionsresonator und einen diesen Detektionsresonator enthaltenden Sigma-Delta-Modulator nach Anspruch 1 umfassend.

9. Messvorrichtung nach Anspruch 8, bei welcher der Detektionsresonator (110a, 210a) ein freier Oszillator ist.

10. Messvorrichtung nach Anspruch 8, Anregungseinrichtungen des Detektionsresonators (210a) umfassend, mit einem zweiten Resonator, Anregungsresonator genannt, gekoppelt mit dem Detektionsresonator.

11. Vorrichtung nach Anspruch 10 mit einem den Anregungsresonator enthaltenden zweiten Sigma-Delta-Modulator.

12. Messvorrichtung nach Anspruch 8, bei welcher der Detektionsresonator mit dem Anregungsresonator durch eine physikalische Größe gekoppelt ist.

13. Vorrichtung nach Anspruch 12, bei der die physikalische Größe eine Corioliskraft ist.

14. Verwendung eines Sigma-Delta-Modulators nach Anspruch 1 in einer Vorrichtung, ausgewählt unter einem Analog-Digitalkonverter, einem Detektor einer physikalischen Größe und einem Signalgenerator.

**Claims**

1. Sigma-delta modulator comprising:

   - at least one resonator (110, 110a, 110b),
   - a converter (120) to convert an analog signal from the resonator into a digital signal with time information, and
   - a feedback loop (140) connecting an output of the converter to an excitation input of the resonator,

   **characterized in that** at least one resonator (110, 110a) in the modulator is chosen from among the group comprising mechanical, acoustic, electromechanical, electrostatic, optical and chemical resonators, the resonator having a mechanical, optical or acoustic excitation input and in which the feedback loop is connected to the excitation input through an electromechanical interface, an electroacoustic interface, or an electrooptical internal of the signal, respectively.

2. Sigma-delta modulator according to claim 1, in which the resonator (110a) is a free oscillator and is equipped with a reaction loop (160) connecting a resonator output to a resonator excitation input.

3. Modulator according to claim 1, comprising a regulation loop (170) connecting an output of the modulator to an excitation input of the resonator.

4. Sigma-delta converter comprising a modulator according to claim 1 and bandpass filter means (130) connected to an output of the modulator.

5. Device for analog-digital conversion of a signal comprising an analog signal input (E) and a sigma-delta converter according to claim 4, the analog signal input being connected to the resonator excitation input.

6. Device according to claim 5, in which the analog input is connected to the excitation input through an electromechanical or electrooptical (112) or electroacoustic interface.

7. Signal generator comprising a sigma-delta modulator according to claim 1, in which at least one resonator (110a) is a free oscillator.

8. Device for measuring a physical magnitude comprising a detection resonator sensitive to said physical magnitude and a sigma-delta modulator according to claim 1, including said detection resonator.

9. Measuring device according to claim 8, in which the detection resonator (110a, 210a) is a free oscillator.

10. Measuring device according to claim 8, comprising means of exciting the detection resonator (210a) with a second resonator called an excitation resonator, coupled to the detection resonator.

11. Device according to claim 10, comprising a second sigma-delta modulator including the excitation resonator.

12. Measuring device according to claim 8, in which the detection resonator is coupled to the excitation resonator through a physical magnitude.

13. Device according to claim 12, in which the physical magnitude is a Coriolis force.

14. Use of a sigma-delta modulator according to claim 1 in a device chosen from among an analog-digital converter, a physical magnitude detector and a signal generator.

FIG. 1

FIG. 2

FIG. 3

FIG. 4

FIG. 5

FIG. 6